Europäisches Patentamt

European Patent Office

Office européen des brevets

(19)

(11) **EP 0 537 066 B1**

(12) **FASCICULE DE BREVET EUROPEEN**

(45) Date de publication et mention
de la délivrance du brevet:
**16.04.1997 Bulletin 1997/16**

(51) Int Cl.<sup>6</sup>: **G01R 31/02**

(21) Numéro de dépôt: **92402734.5**

(22) Date de dépôt: **07.10.1992**

(54) **Procédé de détection sélective d'un défaut résistant dans un réseau de distribution d'énergie électrique**

Verfahren zur selektiven Detektion von Widerstandsdefekten in Stromverteilungsnetzwerken

Method for the selective detection of resistive defects in power-distribution networks

(84) Etats contractants désignés:
**AT CH DE DK ES GB IT LI NL SE**

(30) Priorité: **07.10.1991 FR 9112320**

(43) Date de publication de la demande:
**14.04.1993 Bulletin 1993/15**

(73) Titulaire: **ELECTRICITE DE FRANCE**
**Service National**
**75008 Paris (FR)**

(72) Inventeurs:
• **Griffel, Daniel**
**F-78000 Versailles (FR)**

• **Bergeal, Jean**
**F-91120 Palaiseau (FR)**

(74) Mandataire: **Polus, Camille et al**
**c/o Cabinet Lavoix**
**2, Place d'Estienne d'Orves**
**75441 Paris Cedex 09 (FR)**

(56) Documents cités:
**EP-A- 0 307 826**     **DE-A- 2 400 527**
**FR-A- 1 057 276**     **FR-A- 2 161 752**

**Description**

La présente invention concerne les réseaux de distribution d'énergie électrique qui comportent une ligne d'arrivée qui alimente, par l'intermédiaire de transformateurs, plusieurs lignes de départ de tension plus faible, tels que les réseaux de distribution à moyenne tension. Chaque ligne de départ est généralement équipée d'un dispositif de détection de son courant homopolaire, par exemple un dispositif à tore.

Les défauts qui affectent les réseaux de distribution d'énergie électrique se traduisent par des contacts plus ou moins francs entre des conducteurs ou entre au moins un conducteur et la terre.

Les défauts polyphasés, c'est-à-dire ceux qui affectent au moins deux phases, se traduisent généralement par des courants supérieurs au courant normal de charge de la ligne et peuvent donc être détectés par des dispositifs simples de surveillance des courants de phase, en réalisant une détection de seuil à temps constant.

Les défauts monophasés qui concernent une seule phase et la terre conduisent à des courants dont l'amplitude dépend du mode de mise à la terre de la ligne d'arrivée et de la résistance proprement dite du défaut qui peut être élevée, en particulier pour des réseaux aériens. Pour un grand nombre de ces défauts, qui sont appelés "défauts résistants", la variation du courant n'est pas détectable par des dispositifs simples.

La présente invention concerne la détection des défauts résistants ou très résistants, c'est-à-dire des défauts qui ne peuvent pas être détectés par le dispositif de protection du départ concerné et qui, à l'heure actuelle, sont soit détectés par la protection générale de terre résistante, soit non détectés par des moyens automatiques.

Ces défauts résistants ou très résistants proviennent principalement d'une rupture d'isolement d'une phase par rapport à la terre sur de mauvaises prises de terre, de défauts internes des transformateurs ou de ruptures de conducteurs avec ou sans contact à la terre, que ce soit du côté source ou du côté charge.

Ces défauts présentent des dangers importants pour l'environnement (possibilité d'électrocution ou d'incendie) du fait que leur détection est difficile et entraînent des délais importants de localisation et de neutralisation du défaut.

Par exemple, sur le réseau électrique français, environ un défaut permanent sur huit n'est vu que par le dispositif de détection de terre résistante et un défaut permanent sur sept n'est pas détecté par un dispositif automatique, les exploitants du réseau étant seulement alertés par des tiers constatant une anomalie, telle qu'un fil à terre.

Sur la plupart des réseaux de distribution d'énergie électrique à moyenne tension français actuels (mise à la terre par résistance 300 A), la détection des défauts monophasés à la terre peut être effectuée à trois niveaux :

- au niveau du départ de la ligne moyenne tension par détection au seuil sur la somme des courants de phase fournie par les transformateurs de courant de phase ou sur le courant fourni par un tore spécialisé ;
- au niveau de l'arrivée de la ligne moyenne tension en utilisant les mêmes moyens de mesure ;
- au niveau du transformateur par détection d'un seuil de courant dans la connexion entre le neutre de la moyenne tension et la terre ou par surveillance de la tension homopolaire.

La sensibilité de la détection d'un défaut monophasé à la terre est limitée à une résistance maximale qui est par exemple de 24 kiloohms pour une charge aval minimale de 54 kW en cas de défaut en retour survenant sur un réseau aérien ou de 8 kiloohms correspondant à une charge aval minimale en cas de défaut en retour de 160 kW dans un cas typique moyen.

Il ne s'agit là que de la détection d'un défaut sans localisation du départ en défaut. Il faut alors coupler ce dispositif de détection à un automatisme de recherche qui commande séquentiellement l'ouverture de chacun des barres raccordées au transformateur jusqu'à ce que le défaut disparaisse. Ce dispositif de détection sélective provoque de nombreuses coupures brèves qui perturbent la clientèle. Or la continuité du service sur les réseaux est un facteur qui devient de plus en plus important.

Dans le cas de réseaux mis à la terre par une bobine de compensation, le départ en défaut n'est pas parcouru par le courant homopolaire maximal en cas de défaut à la terre. Par conséquent les protections ampèremétriques à temps inverse adoptées pour détecter sélectivement le départ en défaut sur les réseaux à mise à la terre par résistance ne sont alors plus appropriées. Sur ce type de réseau, les défauts résistants peuvent être détectés par surveillance de la tension homopolaire globale du réseau alimenté par le transformateur ; cette tension est en relation avec la circulation du courant homopolaire engendrée par le défaut dans l'impédance homopolaire (circuit accordé) du réseau.

Dans ce cas, on ne peut détecter le départ en défaut par le processus de l'ouverture séquentielle des départs raccordés au transformateur, car, dans ce cas, la variation de la tension homopolaire consécutive à l'ouverture d'un départ est due, en partie, aux désaccords de circuits de neutre engendrés par cette ouverture et est donc impossible, à moins d'attendre un éventuel réaccord du circuit homopolaire de savoir si la variation de tension homopolaire est due à la disparition du défaut ou bien à la modification de l'accord.

D'après DE-A-2 400 527, on connaissait déjà un procédé de détermination de défauts d'isolation sur des réseaux de distribution électrique notamment de réseaux triphasés, consistant à faire la somme vectorielle des courants de phase et à déterminer si cette somme est nulle auquel cas le réseau est bien équilibré.

En cas de déséquilibre, la détermination de l'emplacement du défaut est assurée en comparant le courant résiduel avec le courant circulant dans une bobine de Petersen reliant le neutre du réseau à la terre.

Ce document décrit en outre un procédé de détermination de défauts d'isolation sur des réseaux de distribution électrique notamment de réseaux triphasés consistant à effectuer des comparaisons de proche en proche des phases des circuits consécutifs d'une installation de distribution.

Il en résulte, que compte tenu des exigences de plus en plus grandes de la distribution d'énergie électrique, il est nécessaire de disposer d'un dispositif permettant une détection sélective sûre et rapide des défauts résistants à la terre sur des réseaux de distribution d'énergie électrique.

L'invention a donc pour objet un procédé de détection sélective d'un défaut résistant sur une ligne de départ d'un réseau de distribution d'énergie électrique comportant une ligne d'arrivée alimentée par un transformateur et plusieurs lignes de départ, chaque ligne de départ étant équipée d'un détecteur de courant homopolaire, caractérisé en ce que l'on mesure en permanence en amplitude et en déphasage le courant homopolaire de chaque départ par rapport à une grandeur de référence, on réalise la somme vectorielle de l'ensemble des courants homopolaires des lignes de départ et on surveille le déphasage de chaque courant homopolaire par rapport au déphasage de ladite somme vectorielle, la présence d'un défaut étant détectée lorsque ledit déphasage d'un courant homopolaire dépasse un seuil négatif prédéterminé.

Selon un premier mode de réalisation, on compare la valeur du déphasage de courant homopolaire de chaque départ par rapport à la valeur de la grandeur de référence pendant un même intervalle de temps.

Selon un autre mode de réalisation de l'invention, on compare la variation du déphasage du courant homopolaire de chaque départ pour une période de temps prédéterminée par rapport à la valeur de la grandeur de référence de la période de temps précédente.

Le principe général du procédé ci-dessus est d'évaluer l'écart de phase existant entre chaque courant homopolaire et la tension homopolaire ou une grandeur liée à cette dernière considérant en les valeurs instantanées des courants homopolaires sur un intervalle de temps fixe, il s'agit alors d'un procédé de type statique, ou en considérant les variations de ces mêmes courants sur un intervalle de temps fixe, il s'agit alors d'une détection de type dynamique.

Il en résulte que l'on détecte la composante active du courant homopolaire de chaque départ, qui est représentative d'une injection de puissance active homopolaire vers la source et traduit donc la présence d'un défaut sur le départ considéré. Il en résulte que le procédé selon l'invention peut fonctionner sur tous les réseaux, et en particulier, sur les réseaux à neutre compensé.

Selon une autre caractéristique de l'invention, le seuil de détection est au moins égal à deux fois la plus grande composante de déséquilibre des courants homopolaires existant en l'absence de défaut.

Ce seuil de déclenchement permet de prendre en compte les dissymétries de construction des différents départs qui induisent des composantes actives et réactives de courant homopolaire conséquence du déséquilibre qui, bien que faibles en général, sont suffisantes pour perturber le procédé de détection selon l'invention, ce qui peut amener à limiter la sensibilité.

Selon une variante de l'invention, le seuil de détection est indépendant des composantes de déséquilibre des courants homopolaires existant en l'absence de défaut.

La réalisation en dynamique du procédé selon l'invention permet également d'éliminer les effets des déséquilibres naturels existant entre les différents départs ; en effet ces déséquilibres varient peu dans le temps et de toute façon de façon lente. Si l'on réalise une détection dynamique par rapport à la tension homopolaire ou une grandeur qui lui est liée, la variation apparente de la composante active sur le départ en défaut est la seule non nulle.

Selon un mode de réalisation de l'invention, on calcule la somme vectorielle des courants homopolaires des départs et on calcule la projection de chaque courant homopolaire de départ sur un axe perpendiculaire à ladite somme vectorielle.

Le repère orthogonal constitué par les signaux de référence peut être obtenu par mesure de la tension homopolaire ou de la grandeur qui lui est liée et produit par le signal obtenu et par un signal décalé d'un quart de période.

Selon une variante de réalisation de l'invention, ce repère orthogonal de référence est obtenu par mesure d'une tension indépendante de la tension homopolaire, telle que la tension entre deux phases du transformateur et par le produit par le signal obtenu et par un signal décalé d'un quart de période.

Selon une autre variante, ce repère orthogonal de référence est déterminé de manière artificielle au début de chaque programme de mesure.

D'autres caractéristiques et avantages de l'invention ressortiront de la description qui suit d'un exemple de réalisation de l'invention, faite en se référant aux dessins annexés sur lesquels :

- la figure 1 représente schématiquement un poste de distribution haute tension/moyenne tension ;
- la figure 2 est un diagramme montrant les courants homopolaires en l'absence de défaut ;
- la figure 3 est un diagramme correspondant au diagramme de la figure 2 dans le cas d'un défaut apparaissant sur un départ ;

- la figure 4 est le schéma d'une portion de réseau ;
- la figure 5 est un organigramme indiquant les différentes phases du procédé selon l'invention ;
- la figure 6 illustre un mode de réalisation de l'invention, et
- les figures 7 et 8 sont des schémas explicatifs du procédé selon l'invention.

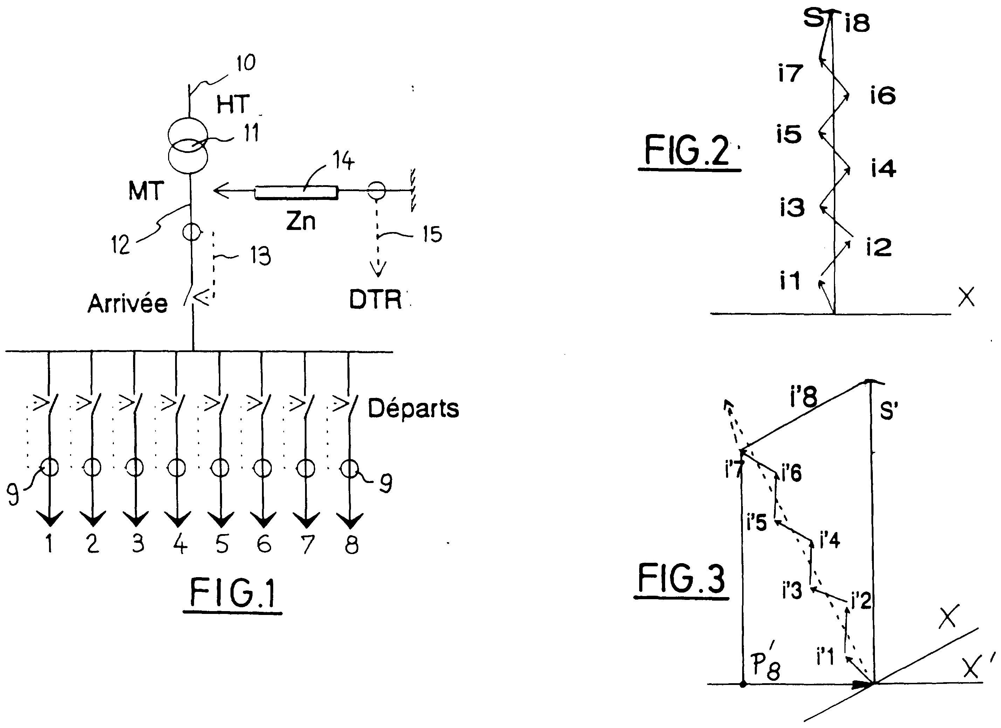

La figure 1 représente un poste de distribution haute tension/moyenne tension d'un réseau électrique ; il comporte une ligne à haute tension 10 qui alimente un transformateur 11 dont le secondaire est branché sur une ligne à moyenne tension 12 ; cette ligne à moyenne tension 12 constitue la ligne d'arrivée et elle alimente, par l'intermédiaire d'un disjoncteur général de protection 13 plusieurs lignes de départ en moyenne tension repérées de 1 à 8 et protégées chacune par un disjoncteur 9.

Le neutre de la ligne d'arrivée à moyenne tension 12 est mis à la terre par l'intermédiaire d'une impédance 14 qui est branchée en série avec un dispositif de détection des terres résistantes 15 qui fournit une alarme au responsable de l'exploitation dans le cas d'un défaut résistant.

Comme indiqué plus haut, les dispositifs de protection 9 sont des protections homopolaires sensibles à temps inverse qui peuvent permettrent d'atteindre un seuil minimal de sensibilité qui est par exemple de 0,7 A, ce qui correspond à une résistance de défaut d'environ 15 kiloohms environ 100 secondes.

Le système de protection 15 est une protection ampèremétrique à seuil qui permet d'obtenir, sans pouvoir identifier le départ en défaut, les sensibilités suivantes:

| type de réseau | résistance maximale du défaut | charge aval minimale en cas de défaut "en retour" |
|---|---|---|
| réseau aérien pur | 24KΩ au mieux | 54 kW |
| cas typique moyen | 8kΩ | 160kW |
| réseau mixte, forte puissance, souterrain important | 2 à 4 kΩ | 320 à 640 kW |

Le dispositif de protection 15 peut, sur certains réseaux, être complété par un dispositif automatique de recherche du départ en défaut commandant séquentiellement l'ouverture des différents départs jusqu'à ce que le défaut disparaisse.

Comme indiqué plus haut, ce dispositif entraîne des coupures brèves dans l'alimentation électrique des clients raccordés au réseau et, de plus, en cas d'échec de cette méthode de détection, il faut couper le disjoncteur d'arrivée.

S'il s'agit d'un réseau qui est mis à la terre par une bobine de compensation, le départ en défaut n'est pas parcouru par le courant homopolaire maximal en cas de défaut à la terre et les protections ampèremétriques à temps inverses 9 ne sont donc plus appropriées.

Comme indiqué plus haut, la recherche du départ en défaut par ouverture séquentielle ne peut pas être utilisée.

Il n'est donc pas possible d'obtenir de manière fiable la détection du départ qui se trouve en défaut, quel que soit le mode de liaison à la terre du réseau considéré (terre résistante, réseau compensé, etc...).

On va maintenant décrire le principe du procédé selon l'invention en application à un réseau compensé.

La figure 2 représente les différents courants homopolaires i1 à i8 qui traversent respectivement les lignes de départ 1 à 8. Chacun des courants homopolaires a été mesuré en amplitude et en déphasage et on réalise ensuite la somme vectorielle de l'ensemble des courants homopolaires des lignes de départ, ce qui fournit le courant homopolaire S qui traverse le dispositif de protection 15.

En l'absence d'un défaut, les courants homopolaires des départs issus d'un même transformateur sont simplement dûs aux déséquilibres naturels de ces départs, en particulier aux dissymétries des phases par rapport à la terre. Dans le cas de réseau compensé, ces courants homopolaires sont peu déphasés entre eux. La composante active de chaque courant homopolaire est représentée par la projection du vecteur de courant sur un axe X perpendiculaire au vecteur somme S.

La figure 3 est un diagramme correspondant à celui de la figure 2 mais lorsqu'un défaut apparait sur l'un des départs, le départ 8 en l'occurrence. Dans ce cas la tension homopolaire est modifiée et l'ensemble des phases des courants homopolaires des différents départs est également modifié. Si la résistance du défaut est suffisamment faible pour que le courant de défaut i'8 soit sensiblement supérieure aux déséquilibres naturels des courants homopolaires des départs, la phase du courant homopolaire de la ligne en défaut s'écarte sensiblement de la phase des autres départs.

En particulier la projection sur un axe X' perpendiculaire à la somme vectorielle S' des courants homopolaires i'1 à i'8 est beaucoup plus importante pour le départ en défaut que pour les autres, car elle est représentative de la puissance active homopolaire qui est injectée par le défaut vers la source. On peut faire la comparaison avec le cas de la figure 2 où il n'y a pas de départ en défaut pour lequel la somme S est représentée en trait interrompu. En effet, la projection P'8 est beaucoup plus importante que les projections correspondant aux autres courants homopolaires i'1 à i'7.

Etant donné que le courant homopolaire global est lié à la tension homopolaire, la surveillance du déphasage du courant homopolaire de chaque ligne de départ par rapport à la tension homopolaire ou à une grandeur qui lui est liée permet donc de détecter de manière fiable et rapide la ligne qui se trouve en défaut.

Le procédé de détection qui vient d'être décrit est de type statique, puisqu'à chaque moment de mesure, on compare le déphasage de chaque courant homopolaire de départ avec la tension homopolaire ou une grandeur qui lui est liée. On peut fixer le seuil de détection à une valeur supérieure à deux fois la composante active maximale normale de déséquilibre du départ concerné. Ceci permet de s'affranchir des perturbations dues au faut que les courants de déséquilibre des départs induisent des composantes actives et réactives de courant homopolaire.

Le procédé qui vient d'être décrit est adapté aux réseaux à neutre compensé ou mis à la terre par résistance. Si on veut accroître la sensibilité, on peut utiliser un procédé dynamique de détection sélective.

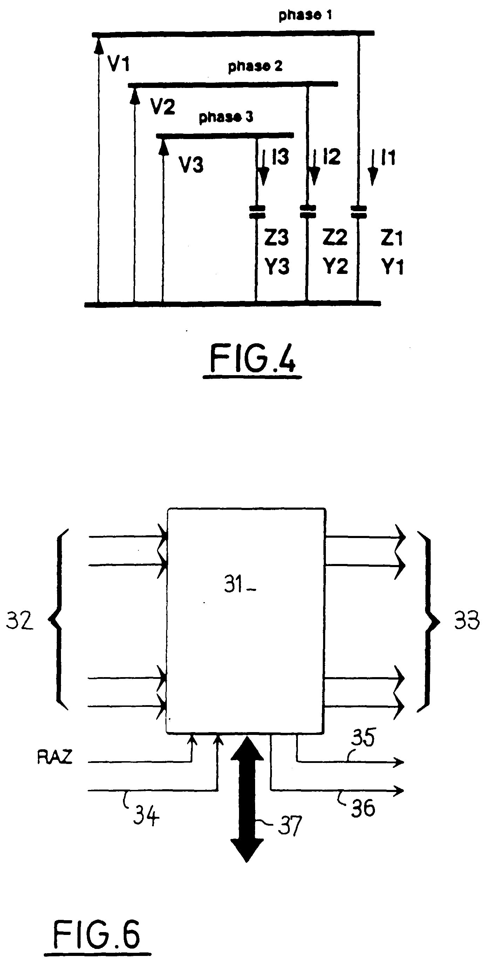

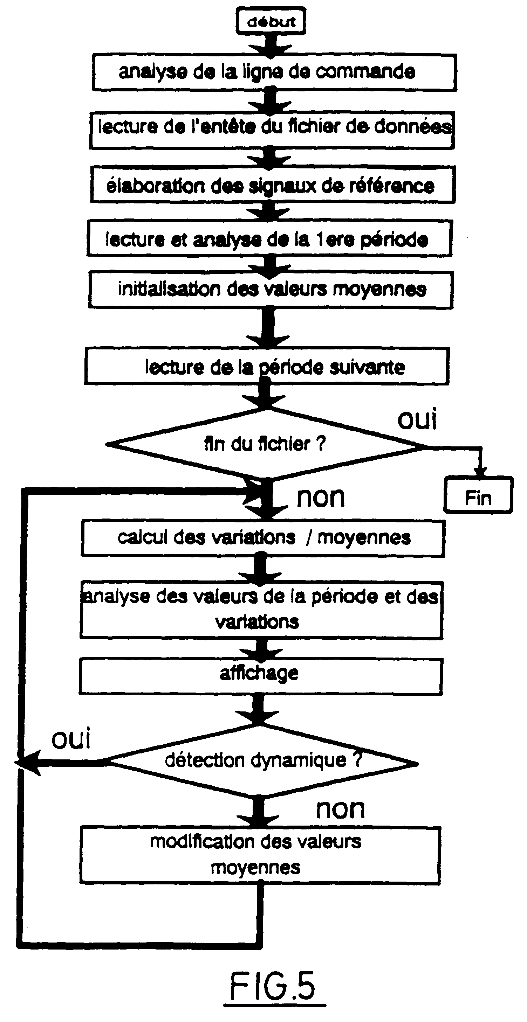

La figure 4 montre de manière schématique une portion de réseau comportant trois phases V1,V2 et V3 qui sont chacune mises à la terre par une capacité présentant une impédance Z1 et une admittance Y1, respectivement Z2 et Y2, Z3 et Y3. On désigne par I1,I2 et I3 les courants circulant dans ces impédances de mise à la terre. Si l'on réalise un calcul utilisant les composantes symétriques définies de la manière suivante :

$$V_1 = V_0 + V_d + V_i$$

$$V_2 = V_0 + a^2 V_d + a V_i$$

$$V_3 = V_0 + a V_d + a^2 v_i$$

$$I_1 = V_1 Y_1$$

$$I_2 = V_2 Y_2$$

$$I_3 = V_3 Y_3$$

en admettant que le courant homopolaire global est généralement faible devant le courant capacitif global (de l'ordre de quelques millièmes) et que, lors d'un défaut à la terre, la tension directe Vd est nettement supérieure à la tension inverse $V_i$, on en conclut que, quels que soit les déséquilibres initiaux des différentes lignes de départ, seul le départ en défaut présente une variation de son courant homopolaire qui est déphasée par rapport à la variation du courant homopolaire de tous les autres défauts.

Dans ce cas, conformément à l'invention, on effectue une détection dynamique en surveillant les variations du courant homopolaire de chaque départ et en comparant la phase de chacune des variations par rapport à celles de tous les autres départs. Si un départ est en défaut, la variation de son courant homopolaire est fortement déphasée par rapport à la variation du courant homopolaire des autres départs. On réalise alors non pas une détection d'écart de phase des valeurs des courants homopolaires mais de leur variation. Ce procédé de détection dynamique permet d'améliorer notablement la sensibilité du dispositif de détection sélective selon l'invention.

Conformément à l'invention, la phase de la tension homopolaire est évaluée en calculant la somme vectorielle des courants homopolaires ; ceci permet d'éviter une mesure de tension qui augmente le coût du dispositif si la tension homopolaire n'est pas disponible; par ailleurs le dispositif selon l'invention est indépendant de toute autre protection qui utilise la tension homopolaire.

On réalise donc une analyse des écarts de phase entre chaque courant homopolaire et la somme des courants homopolaires dans le cas de la détection statique et une analyse de la variation de ces écarts dans le cas de la détection dynamique.

La figure 5 est un organigramme qui illustre le procédé selon l'invention. Ce procédé est réalisé au moyen d'un équipement informatique commandé par un programme.

Lors de la mise en route, on effectue tout d'abord une analyse de la ligne de commande puis une lecture de l'entête du fichier de données. Cette opération est suivie d'une phase d'élaboration des signaux de référence qui seront commentés plus loin.

Lors de la première période de mesure on effectue une lecture et une analyse et on en déduit des valeurs moyennes de la composante active de chacun des courants homopolaires ; cette phase est une phase d'initialisation, ces valeurs moyennes étant utilisées pour toute la série de mesures, si l'on réalise une détection de type dynamique.

On effectue ensuite la mesure pour la période suivante et l'on calcule les variations par rapport aux valeurs moyennes déterminées précédemment. Cette opération est suivie par une analyse des valeurs et ou des variations de la période considérée qui peuvent être affichées.

Si l'on utilise une détection dynamique, on répète le processus de calcul des variations et des moyennes de l'analyse des valeurs et des variations ; s'il s'agit d'une détection statique, on procède tout d'abord à la modification des valeurs moyennes.

Le fichier de données est un fichier issu d'enregistrements perturbographiques. Il est évident que l'on ne peut effectuer de détection dynamique que si l'on a déjà enregistré une période pendant laquelle il n'y avait pas de défaut.

Les calculs effectués lors de la réalisation de ce programme informatique consistent à évaluer, pour chaque voie correspondant à un départ, la projection du vecteur représentant le courant homopolaire sur un axe perpendiculaire X ou X' au vecteur représentant la somme des courants homopolaires S ou S' (voir figure 3). Ceci revient à calculer la partie imaginaire du nombre complexe représentant la valeur du courant homopolaire dans un système d'axes (réel-imaginaire) fourni par la somme temporelle des valeurs de courant homopolaire. A cet effet, on utilise deux signaux de référence orthogonaux arbitraires (désignés par sin x et cos x) et l'on calcule pour chaque voie le terme fondamental de la série de Fourier associée à cette voie. On pratique de même sur la somme temporelle des voies après l'avoir calculée.

Chaque voie, ainsi que la somme des voies, est alors représentée par un nombre complexe dans un système d'axes réel-imaginaire arbitraire. On calcule alors pour chaque voie le nombre complexe obtenu par rotation vers la somme. Dans ce nouveau système d'axes, la somme a une valeur réelle égale à son module et une valeur imaginaire nulle.

Pour obtenir le signal de référence, on peut utiliser trois méthodes. La première consiste à détecter la tension hompolaire et en effectuer le produit par le signal obtenu et par un signal décalé d'un quart de période.

La deuxième méthode consiste à mesurer une tension indépendante de la tension homopolaire, par exemple une tension issue de la tension existant entre deux phases du transformateur, telle que la tension d'alimentation des auxiliaires du poste de distribution qui constituera aussi la tension d'alimentation du dispositif de détection sélective.

Une troisième méthode consiste à élaborer de manière artificielle une référence, sin (x) et cos (x), qui sera calculée une fois pour toute au début du programme pour chaque point. Cette dernière méthode est simple et elle ne nécessite aucune mesure ou acquisition de signal supplémentaire.

Les variations sont calculées point par point en effectuant la différence entre des valeurs moyennes enregistrées et les valeurs venant d'être lues. Cette différence temporelle étant faite, on calcule la somme temporelle de ces différences et on effectue les mêmes calculs sur les valeurs obtenues que sur les valeurs lues.

Les valeurs moyennes sont initialisées après la lecture de la première période. Elle sont ensuite modifiées après chaque période et l'on n'effectue pas de détection dynamique. Les nouvelles valeurs moyennes sont alors choisies égales à la moyenne entre les anciennes valeurs moyennes et les valeurs venant d'être lues.

La détection s'effectue ensuite par évaluation des projections de chaque voie sur la somme temporelle des voies en effectuant ensuite une comparaison des valeurs imaginaires de ces projections, la somme de ces parties imaginaires étant évidemment nulle.

Cette partie imaginaire est obligatoirement négative pour le départ en défaut. Elle peut être positive ou négative pour les départs sains. De toute façon la partie imaginaire du départ en défaut est minimale, c'est-à-dire qu'elle a la plus forte valeur négative.

La détection consiste donc à vérifier que le seuil est atteint par le départ qui présente la partie imaginaire la plus forte en valeur absolue. La détection statique s'effectue sur les valeurs venant d'être lues en effectuant la comparaison avec le seuil statique.

La détection dynamique s'effectue en prenant en compte les différences entre les valeurs venant d'être lues et les valeurs moyennes et en effectuant les comparaisons avec le seuil dynamique.

Les résultats sont affichés sur un écran et il est possible de les envoyer sur une imprimante ou un fichier ou toute interface de sortie. Les périodes pour lesquelles une modification de l'état détecté est intervenue apparaissent avec l'indication de la modification (début ou fin) et du type de détection (statique ou dynamique).

Dans le cas d'une fin (disparition de défaut), on indique le nombre de périodes pendant lesquelles le défaut a été constaté ainsi que le module maximal atteint pour le courant de défaut.

Le tableau ci-dessous est un exemple d'un tel affichage.

```
DESIR V 3.0 Detection Selective par les Intensites
Residuelles

COPYRIGHT (C) EDF 1991
EDF/DER/ER/FORCAM/PADT - D GRIFFEL J BERGEAL
-avril 1991

Analyse du fichier DESIR031.SPV
POSTE GUEBWILLER le 16 02 91 à 10h 03 mn 41s
                 périodes 1 à 43
per  2 : deb stat v4 (    0.52)
per  4 : deb dyna v4 (    0.28)
per 12 : fin stat v4 (    1.060 sur 10 per)
         fin dyna v4 (    0.364 sur  8 per)
per 19 : deb dyna v4 (    0.21)

defaut sur voie 4 (dynamique)
depuis 25 période(s) 0.450

execution terminee normalement
```

On voit qu'il est apparu un défaut en détection statique sur la voie n°4 à la période n°2 avec un module de courant de 0,52 A ; ce défaut disparaît à la période 12. Il est indiqué que le maximum du module a été de 1,06 A pour ce défaut détecté de manière statique qui a duré 10 périodes. Sur ce tableau, on voit également les résultats de la détection dynamique. Il apparait un défaut sur la voie 4 à la période 4 avec une valeur de 0,28 A. Ce défaut disparaît à la période 12 après avoir atteint un maximum de 0,364 A puis réapparait à la période 19 avec un module de 0,21 A.

Ce défaut détecté en dynamique reste présent à la fin du fichier depuis 25 périodes son module maximum ayant été de 0,45 A. Dans le cas présent il devrait s'agir d'un défaut qui existait avant le déclenchement de l'enregistrement perturbographique.

Avantageusement, on réalise un affichage complet fournissant pour chaque voie et pour la somme temporelle des voies :

- les valeurs moyennes et efficaces pour la période ;
- les valeurs réelles et imaginaires ainsi que le module et l'argument dans le système de référence arbitraire ; et
- les valeurs réelles et imaginaires après rotation vers le système d'axes fourni par la somme temporelle des voies.

Les mêmes valeurs sont ensuite données pour les différences entre les valeurs lues et les valeurs moyennes. Un exemple d'un tel affichage est fourni par le tableau suivant.

| période 4 | | | | | | | | |
|---|---|---|---|---|---|---|---|---|
| val; | moy; | eff; | reel; | imag; | mod; | arg; | reel/S; | imag/S |
| val 1; | 0.406; | 11.254; | -12.291; | 9.776; | 15.705; | 2.470; | 15.035; | 4.538 |
| val 2; | -0.438; | 9.131; | -6.792; | 10.826; | 12.780; | 2.131; | 12.767; | -0.579 |
| val 3; | -0.563; | 6.052; | -6.579; | 5.303; | 8.450; | 2.463; | 8.105; | 2.389 |
| val 4; | -0.563; | 13.859; | 7.114; | 18.057; | 19.408; | 1.196; | 10.795; | -16.129 |
| val 5; | -0.313; | 5.761; | -6.186; | 5.186; | 8.072; | 2.444; | 7.785; | 2.133 |
| val 6; | -0.250; | 3.410; | -3.762; | 2.882; | 4.739; | 2.488; | 4.511; | 1.452 |
| val 7; | -0.531; | 10.910; | -11.632; | 9.949; | 15.306; | 2.434; | 14.802; | 3.899 |
| val 8; | -0.219; | 5.593; | -6.157; | 4.856; | 7.842; | 2.474; | 7.498; | 2.297 |
| val S; | -2.469; | 57.815; | -46.285; | 66.835; | 81.297; | 2.176; | 81.297; | 1153.875 |

(suite)

| période 4 | | | | | | | | |
|---|---|---|---|---|---|---|---|---|
| dif; | moy; | eff; | reel; | imag; | mod; | arg; | reel/S; | imag/S |
| dif 1; | 0.172; | 11.746; | -13.163; | 9.865; | 16.450; | 2.498; | 16.371; | 1.605 |
| dif 2; | 0.164; | 10.291; | -11.405; | 8.871; | 14.449; | 2.481; | 14.403; | 1.152 |
| dif 3; | 0.023; | 5.666; | -6.267; | 4.874; | 7.939; | 2.481; | 7.914; | 0.634 |
| dif 4; | 0.305; | 5.162; | -0.209; | 6.727; | 6.730; | 1.602; | 4.695; | -4.822 |
| dif 5; | -0.102; | 6.148; | -6.516; | 5.658; | 8.630; | 2.427; | 8.627; | 0.223 |
| dif 6; | 0.188; | 4.085; | -4.116; | 3.971; | 5.719; | 2.374; | 5.717; | -0.152 |
| dif 7; | 0.258; | 10.245; | -11.333; | 8.860; | 14.385; | 2.478; | 14.342; | 1.112 |
| dif 8; | 0.094; | 7.111; | -7.541; | 6.564; | 9.998; | 2.425; | 9.995; | 0.247 |
| dif S; | 1.102; | 58.542; | -60.550; | 55.391; | 82.064; | 2.401; | 82.064; | 1153.875 |
| | | | | | stat v4 ( | | 0.95) deb dyna v4 ( | 0.28) |

La figure 6 représente schématiquement le système informatique réalisant ce programme. Il doit réaliser l'acquisition du courant homopolaire de chacun des départs alimentés par le même transformateur. Par exemple on peut utiliser un système d'acquisition sur 10 bits mesurant 32 points par période. L'algorithme de détection peut être facilement transformé pour fonctionner avec des valeurs entières.

Les signaux de référence sont adaptés pour fournir des résultats entiers significatifs lors des multiplications avec les valeurs d'entrée ; on peut par exemple prendre comme signaux les parties entières de 1024 * sin x et 1024 * cos x qui présentent l'avantage de permettre de remplacer les multiplications et divisions par des décalages simples (1024 = $2^{10}$). Il convient toute fois d'éviter les débordements éventuels lors du calcul des parties imaginaires par rotation (résultats sur 32 bits). La division par le module de la somme, nécessaire pour retrouver le module du courant de défaut après rotation, peut être remplacée par une division par la somme des valeurs absolues et imaginaires de la somme des voies s'il s'avère que le calcul d'une racine carrée est trop consommateur de temps.

Selon une variante, on utilise une tension indépendante de la tension homopolaire telle qu'une tension d'alimentation prise entre deux phases comme signal de référence. Cette solution présente l'inconvénient d'utiliser une voie d'acquisition supplémentaire.

Si l'on choisit cette solution, seuls les calculs utiles à la détection doivent être implantés (les calculs de valeurs moyennes et efficaces, de module et d'argument sont superflus). Les opérations indispensables sont :

- l'élaboration de signaux moyens par voie ;
- le calcul de la somme temporelle des entrées ;
- le calcul des termes fondamentaux des entrées de la somme temporelle par produit avec sin x et cos x, en synchronisme avec l'échantillonnage, qui peuvent être implantés sous forme de données fixes ;
- calcul de la partie imaginaire obtenue par rotation de chaque voie vers la somme temporelle des voies ;
- calcul des différences temporelles pour chaque voie et mêmes calculs que précédemment sur les différences entre les valeurs d'entrées et les valeurs moyennes; et
- comparaison des résultats à un seuil paramétrable.

Suivant les performances du système informatique utilisé, on pourra soit exécuter les acquisitions et calculs en temps réel, soit établir un séquencement acquisition-calcul sur quelques périodes.

Sur la figure 6, on voit un système informatique 31 qui reçoit en entrée des valeurs de courants homopolaires 32 et fournit en sortie des signaux 33 indiquant la voie en défaut. Ce système informatique reçoit par ailleurs en 34 une tension d'alimentation qui peut être utilisée comme système de référence. Les sorties 35 et 36 indiquent respectivement s'il s'agit d'une détection statique ou dynamique. Enfin, le système 31 est relié à un réseau de comunication 37 grâce auquel on peut effectuer la programmation et le paramétrage du système 31.

Les entrées 32 sont fournies par les transformateurs de courant des dispositifs de protection 9 de chaque départ.

Les niveaux d'entrées doivent être adaptés à la sensibilité désirée et au nombre de bits de la conversion analogique-numérique effectuée.

A titre d'exemple, pour détecter des défauts de l'ordre de 120 kiloohms avec une amplitude relativement confortable de trois quanta pour les calculs, on aura :

0,1 A eff HTA $\to$ 1,77 mA max BT

soit 1,77 mA sur 3 quanta $\to$ 1,77 * 512/3 $\to$ 300 mA pleine échelle sur 10 bits.

Le courant maximal obtenu en cas de défaut double est de l'ordre de 10 000 A du côté de la moyenne tension soit 10 000 * 5/400 = 125 A.

Dans un premier temps les sorties seront envoyées vers un perturbographe. Le déclenchement de celui-ci sera assuré par l'une ou l'autre des signalisations de détection statique ou dynamique. Les sorties logiques correspondant à la signalisation de la voie en défaut seront acquises par le perturbographe qui assurera également l'acquisition des courants résiduels dans les mêmes conditions que le système. On pourra ainsi consulter à distance les informations fournies et vérifier le fonctionnement du système, éventuellement après un appel automatique du perturbographe.

Par la suite les sorties logiques pourront être traitées directement par le contrôle commande du poste source pour élaborer des alarmes ou directement commander l'ouverture du départ en défaut.

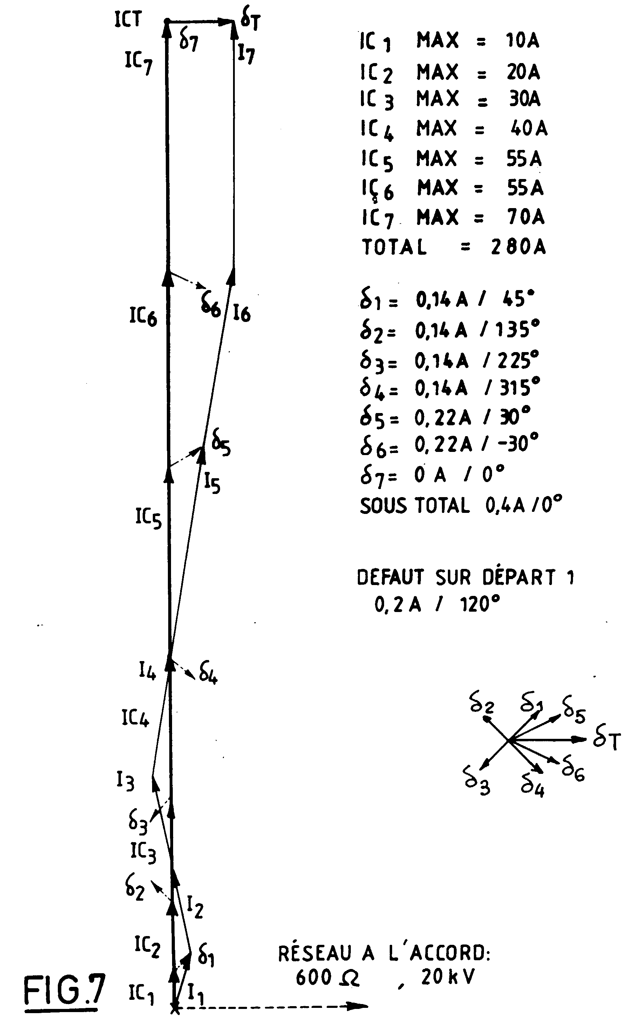

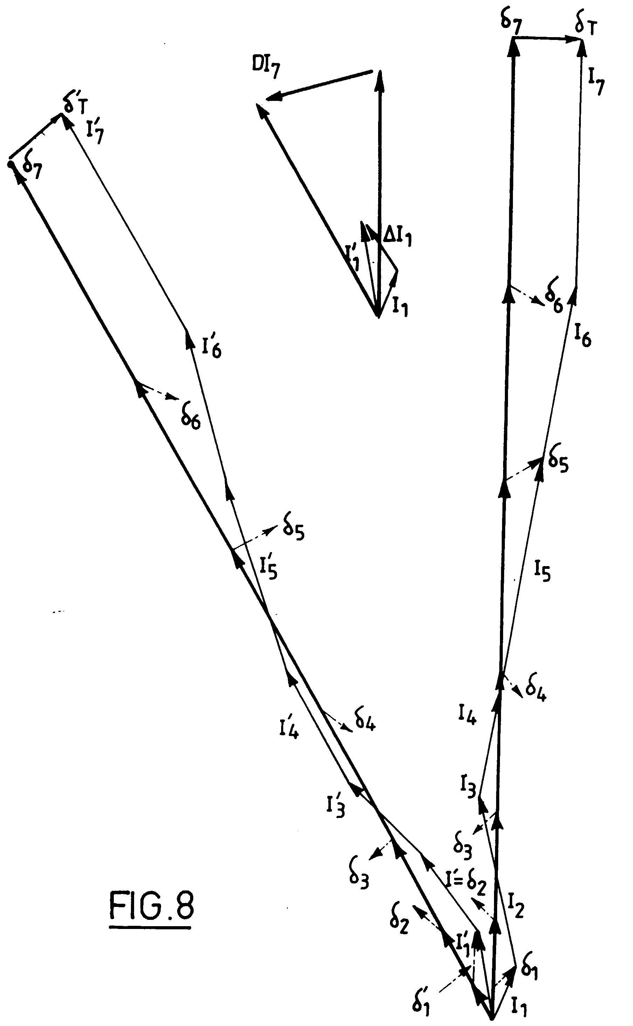

Les figures 7 et 8 sont des diagrammes expliquant le procédé selon l'invention.

Sur la figure 7 on a représenté les courants homopolaires $I_1$ à $I_7$ d'un réseau de distribution. Les parties actives de ces courants homopolaires sont respectivement désignées pas $I_{C1}$ à $I_{C7}$. Pour chacun des courants homopolaires on détermine son écart par rapport à la composante active, à savoir $\delta_1$ à $\delta_7$ ; dans l'exemple représenté l'écart du courant $I_7$ est nul. Les valeurs des différents courants ont été indiquées sur la figure.

La somme vectorielle des écarts $\delta_1$ à $\delta_7$ donne l'écart $\delta_T$ du courant homopolaire global.

Sur la figure 8, on a représenté sur la partie gauche le même réseau avec un défaut de 0,2 A avec 120° de déphasage sur le départ 1, à savoir le courant i'1, les autres courants étant restés sensiblement les mêmes. Dans ce cas on détermine également l'écart $\delta_1$ à $\delta_7$ dont la somme vectorielle fournit le nouvel écart global $\delta'_T$.

On voit que l'invention permet de réaliser de manière fiable et rapide la détection d'un défaut résistant sur un départ d'un poste de distribution d'énergie électrique. Ceci est obtenu quelle que soit le mode de mise à la terre du neutre du réseau moyenne tension.

L'utilisation du procédé dynamique permet encore d'améliorer la sensibilité du dispositif puisque l'on peut détecter des défauts dont la résistance peut aller jusqu'à 120 kiloohms.

Le procédé selon l'invention permet d'améliorer la sécurité des tiers et des installations au voisinage des canalisations électriques à moyenne tension ainsi que la qualité de service de ces réseaux en réduisant le nombre des coupures brèves.

Le procédé selon l'invention permet également de fournir une mesure des courants capacitifs homopolaires de chaque départ ainsi que de son déséquilibre naturel propre ; il permet ainsi d'établir une carte des déséquilibres naturels. Il permet aussi de détecter les autres types de défauts à la terre, y compris les défauts francs sur une terre à résistance nulle.

## Revendications

1. Procédé de détection sélective d'un défaut résistant sur une ligne de départ d'un réseau de distribution d'énergie électrique comportant une ligne d'arrivée (12) alimentée par un transformateur (11) et plusieurs lignes de départ (1-8), chaque ligne de départ étant équipée d'un détecteur de courant homopolaire (9), caractérisé en ce qu'on mesure en permanence en amplitude et en déphasage le courant homopolaire (i1-i8;i'1-i'8) de chaque départ (1-8) par rapport à une grandeur de référence, en ce qu'on réalise la somme vectorielle de l'ensemble des courants homopolaires des lignes de départ et on surveille le déphasage de chaque courant homopolaire par rapport au déphasage de ladite somme vectorielle, la présence d'un défaut étant détectée lorsque ledit déphasage d'un courant homopolaire dépasse un seuil négatif prédéterminé.

2. Procédé de détection sélective selon la revendication 1, caractérisé en ce que l'on compare la valeur du déphasage de courant homopolaire de chaque départ par rapport à la valeur de la grandeur de référence pendant un même intervalle de temps.

3. Procédé de détection sélective selon la revendication 1, caractérisé en ce que l'on compare la variation du déphasage du courant homopolaire de chaque départ pour une période de temps prédéterminée par rapport à la valeur de la grandeur de référence de la période de temps précédente.

4. Procédé de détection sélective selon la revendication 1, caractérisé en ce que l'on calcule la somme vectorielle (S;S') des courants homopolaires (i-i8;i'1-i'8) des départs (1-8) et que l'on calcule la projection (P'8) de chaque courant homopolaire de départ sur un axe perpendiculaire à ladite somme vectorielle (S;S').

5. Procédé de détection sélective selon la revendication 4, caractérisé en ce que, pour calculer ladite projection, on utilise deux signaux de référence orthogonaux arbitraires, on calcule le terme fondamental de la série de Fourier associée pour chaque courant homopolaire de départ (i1-i8;i'1'-i'8) ainsi que pour la somme (S;S') et on calcule, dans le système d'axes orthogonaux constitué par lesdits deux signaux, pour chaque courant homopolaire, le nombre complexe obtenu par rotation vers la somme (S:S') de manière à obtenir une valeur réelle égale au module de courant homopolaire de départ et une valeur imaginaire nulle.

6. Procédé de détection sélective selon la revendication 5, caractérisé en ce que les deux signaux de référence sont obtenus par mesure de la tension homopolaire ou de la grandeur qui lui est liée et produits par le signal obtenu et par un signal décalé d'un quart de période.

7. Procédé de détection sélective selon la revendication 5, caractérisé en ce que lesdits signaux de référence sont obtenus par mesure d'une tension indépendante de la tension homopolaire, telle que la tension entre deux phases du transformateur et par le produit par le signal obtenu et par un signal décalé d'un quart de période.

8. Procédé de détection sélective selon la revendication 5, caractérisé en ce que les signaux de référence sont déterminés de manière artificielle au début de chaque programme de mesure.

9. Procédé de détection sélective selon la revendication 2, caractérisé en ce que le seuil de détection est au moins égal à deux fois la plus grande composante de déséquilibre des courants homopolaires existant en l'absence de défaut.

10. Procédé de détection sélective selon la revendication 3, caractérisé en ce que le seuil de détection est indépendant des composantes de déséquilibre des courants homopolaires existant en l'absence de défaut.

## Patentansprüche

1. Verfahren zur selektiven Erfassung einer ohmschen Störung auf einer ausgehenden Leitung eines elektrisches Energieversorgungsnetzes, welches eine ankommende Leitung (12), die über einen Transformator (11) versorgt wird, und mehrere ausgehende Leitungen (1-8) umfaßt, wobei jede ausgehende Leitung mit einem Nullstromdetektor (9) ausgerüstet ist,
   **dadurch gekennzeichnet**, daß Amplitude und Phasenverschiebung des Nullstromes (i1-i8; i'1-i'8) jeder ausgehenden Leitung (1-8) ununterbrochen mit Referenz auf eine Bezugsgröße gemessen, daß die Vektorsumme der Gesamtheit der Nullströme der ausgehenden Leitungen gebildet und daß die Phasenverschiebung jedes Nullstroms im Vergleich zu der Phasenverschiebung der Vektorsumme überwacht wird, wobei das Vorhandensein eines Fehlers erkannt wird, wenn die Phasenverschiebung eines Nullstroms eine vorherbestimmte, negative Schwelle überschreitet.

2. Verfahren für eine selektive Erfassung gemäß Anspruch 1,
   **dadurch gekennzeichnet**, daß der Wert der Phasenverschiebung des Nullstroms jeder ausgehenden Leitung mit dem Wert der Bezugsgröße aus dem gleichen Zeitintervall verglichen wird.

3. Verfahren für eine selektive Erfassung gemäß Anspruch 1,
   **dadurch gekennzeichnet**, daß die Änderung der Phasenverschiebung des Nullstroms jeder ausgehenden Leitung während einer vorherbestimmten Zeitperiode mit dem Wert der Bezugsgröße der vorangegangenen Zeitperiode verglichen wird.

4. Verfahren für eine selektive Erfassung gemäß Anspruch 1,
   **dadurch gekennzeichnet**, daß die Vektorsumme (S;S') der Nullströme (i1-i8; i'1-i'8) der Ausgänge (1-8) berechnet wird und daß die Projektion (P'8) jedes ausgehenden Nullstroms auf eine Achse senkrecht zur der Vektorsumme (S;S') berechnet wird.

5. Verfahren für eine selektive Erfassung gemäß Anspruch 4,
   **dadurch gekennzeichnet**, daß, um besagte Projektion zu berechnen, zwei willkürliche, orthogonale Referenzsignale verwendet werden, daß das Anfangsglied der entsprechenden Fourierreihe für jeden ausgehenden Nullstrom (i1-i8; i'1-i'8) sowie für die Summe (S;S') berechnet wird, und daß in dem orthogonalen Achsensystem, welches gebildet wird durch die zwei Signale, für jeden Nullstrom die komplexe Zahl berechnet wird, die durch Rotation in Richtung der Summe (S:S') erhalten wird, auf solche Weise, daß ein reeller Wert gleich dem Betrag des ausgehenden Nullstromes und ein imaginärer Wert von Null erzielt wird.

**6.** Verfahren für eine selektive Erfassung gemäß Anspruch 5,
**dadurch gekennzeichnet**, daß die beiden Referenzsignale durch die Messung der Nullspannung oder einer ihr entsprechenden Größe, und aus Produkten aus dem erhaltenen Signal und einem Signal, welches um eine viertel Periode verschoben ist, erhalten werden.

**7.** Verfahren für eine selektive Erfassung gemäß Anspruch 5,
**dadurch gekennzeichnet**, daß die Referenzsignale durch die Messung einer von der Nullspannung unabhängigen Spannung, d. h. der Spannung zwischen zwei Phasen des Transformators, und durch das Produkt aus dem erhaltenen Signal und einem Signal, welches um eine viertel Periode verschoben ist, erhalten werden.

**8.** Verfahren für eine selektive Erfassung gemäß Anspruch 5,
**dadurch gekennzeichnet**, daß die Referenzsignale auf eine künstliche Weise zu Beginn jedes Meßprogramms bestimmt werden.

**9.** Verfahren für eine selektive Erfassung gemäß Anspruch 2,
**dadurch gekennzeichnet**, daß die Schwelle für die Erfassung mindestens gleich dem zweifachen der größten Komponente der Ausgleichsströme ist, die in Abwesenheit einer Störung existieren.

**10.** Verfahren für eine selektive Erfassung gemäß Anspruch 3,
**dadurch gekennzeichnet**, daß die Schwelle für die Erfassung unabhängig ist von den Komponenten der Ausgleichsströme, die in Abwesenheit einer Störung existieren.

## Claims

**1.** Method for selective detection of a resistive defect on an outgoing circuit of an electrical power-distribution network, comprising an incoming circuit (12) supplied by a transformer (11) and several outgoing circuits (1-8), each outgoing circuit being provided with a zero current detector (9), characterised in that the zero current (i1-i8;i'1-i-8) of each output (1-8) is measured continuously, in terms of the amplitude and the phase shift, in relation to a reference magnitude; in that the vectorial sum of all the zero currents of the outgoing circuits is found and in that the phase shift of each zero current is monitored in relation to the phase shift of said vectorial sum, the presence of a fault being detected when said phase shift of a zero current exceeds a predetermined negative threshold.

**2.** Method for selective detection according to Claim 1, characterised in that the value of the phase shift of the zero current of each output is compared in relation to the value of the reference magnitude for a same time interval.

**3.** Method for selective detection according to Claim 1, characterised in that the variation of the phase shift of the zero current of each output is compared, for a predetermined time period, in relation to the value of the reference magnitude of the preceding time period.

**4.** Method for selective detection according to Claim 1, characterised in that the vectorial sum (S;S') of the zero currents (i-i8;i'1-i'8) of the outputs (1-8) is calculated and the projection (P'8) of each zero output current on an axis which is perpendicular to said vectorial sum (S;S') is calculated.

**5.** Method for selective detection according to Claim 4, characterised in that, to calculate said projection, two arbitrary orthogonal reference signals are used, the fundamental term of the associated Fourier series is calculated for each zero output current (i1-i8;i'1-i'8) and for the sum (S;S') and there is calculated, in the system of orthogonal axes formed of said two signals, for each zero current, the complex number obtained by rotation towards the sum (S: S') in such a manner as to obtain a real part equal to the modulus of the zero output current and a zero imaginary part.

**6.** Method for selective detection according to Claim 5, characterised in that the two reference signals are obtained by measuring the zero voltage or the magnitude which is associated therewith and are produced by the signal which is obtained and by a signal which is offset by a quarter of the period.

**7.** Method for selective detection according to Claim 5, characterised in that said reference signals are obtained by measuring a voltage which is independent of the zero voltage, such as the voltage between two phases of the transformer, and by the product of the signal obtained and a signal which is offset by a quarter of the period.

8. Method for selective detection according to Claim 5, characterised in that the reference signals are determined in an artificial manner at the start of each measuring program.

9. Method for selective detection according to Claim 2, characterised in that the detection threshold is at least twice the largest component of the unbalance of the zero currents existing in the absence of a fault.

10. Method for the selective detection according to Claim 3, characterised in that the detection threshold is independent of the components of unbalance of the zero currents existing in the absence of a fault.

EP 0 537 066 B1

FIG.1

FIG.2

FIG.3

FIG.4

FIG.6

14

début

analyse de la ligne de commande

lecture de l'entête du fichier de données

élaboration des signaux de référence

lecture et analyse de la 1ere période

initialisation des valeurs moyennes

lecture de la période suivante

fin du fichier ?

oui

non

Fin

calcul des variations / moyennes

analyse des valeurs de la période et des variations

affichage

détection dynamique ?

oui

non

modification des valeurs moyennes

FIG.5

FIG.7

ICT
δ7    δT
IC7    I7

IC6    δ6    I6

δ5
I5
IC5

I4    δ4
IC4

I3
δ3
IC3

δ2    I2

IC2    δ1
IC1    I1

IC₁  MAX  =  10A
IC₂  MAX  =  20A
IC₃  MAX  =  30A
IC₄  MAX  =  40A
IC₅  MAX  =  55A
IC₆  MAX  =  55A
IC₇  MAX  =  70A
TOTAL    =  280A

$\delta_1$ =  0,14 A / 45°
$\delta_2$ =  0,14 A / 135°
$\delta_3$ =  0,14 A / 225°
$\delta_4$ =  0,14 A / 315°
$\delta_5$ =  0,22 A / 30°
$\delta_6$ =  0,22 A / -30°
$\delta_7$ =  0 A  / 0°
SOUS TOTAL  0,4A /0°

DEFAUT SUR DÉPART 1
  0,2 A  /  120°

RÉSEAU A L'ACCORD:
  600 Ω   , 20 kV

FIG.8